# EUROPEAN PATENT APPLICATION

(11) **EP 4 435 853 A1**
(43) Date of publication of application: **25.09.2024**
(21) Application number: 23211600.4
(22) Date of filing: 22.11.2023
(51) Int. Cl.: H01L 23/485, H01L 23/528

(54) **SEMICONDUCTOR DEVICE**

(30) Priority: 22.03.2023 KR 20230037535
(71) Applicant: Samsung Electronics Co., Ltd., Suwon-si, Gyeonggi-do 16677 (KR)
(72) Inventor: PARK, Juneyoung, 16677 Suwon-si (KR); SHIN, Heonjong, 16677 Suwon-si (KR); SHIN, Jongmin, 16677 Suwon-si (KR); JANG, Jaeran, 16677 Suwon-si (KR)
(74) Representative: Marks & Clerk LLP

(57) **Abstract**

Provided is a semiconductor device including an active device layer including a plurality of source/drain patterns, a plurality of insulating layers on the active device layer, a back end of line (BEOL) structure on the plurality of insulating layers and configured to supply electric power to the active device layer, an intermediate layer between the plurality of insulating layers and the BEOL structure, and at least one power via penetrating through the intermediate layer and at least a part in each of the plurality of insulating layers in a vertical direction. The at least one power via electrically connects the BEOL structure and the active device layer. At least a part of a side surface of the at least one power via is in contact with the intermediate layer.

## Description

### BACKGROUND

The inventive concepts in general relate to semiconductor devices, and more particularly, to semiconductor devices including a field-effect transistor and methods of manufacturing the same.

When a semiconductor apparatus includes signal wires and active devices for signal routing on a front surface of an active device layer and a power distribution network (PDN) for electric power supply on a rear surface of the active device layer, a backside power distribution network (BSPDN) semiconductor apparatus may separate the signal wires from the PDN provided on the active device layer. A BSPDN semiconductor apparatus may minimize routing complexity and reduce the area of a semiconductor architecture.

### SUMMARY

One or more example embodiments of the present inventive concepts provide a semiconductor device capable of reducing mis-alignment of a power via and source/drain patterns.

According to some example embodiments of the inventive concepts, there is provided a semiconductor device including an active device layer including a plurality of source/drain patterns, a plurality of insulating layers on the active device layer, a back end of line (BEOL) structure on the plurality of insulating layers and configured to supply electric power to the active device layer, an intermediate layer between the plurality of insulating layers and the BEOL structure, and at least one power via penetrating through the intermediate layer and at least a part of each insulating layer of the plurality of insulating layers in a vertical direction, and the at least one power via electrically connected to the BEOL structure and the active device layer, wherein at least a part of a side surface of the at least one power via is in contact with the intermediate layer.

According to some example embodiments of the inventive concepts, there is provided a semiconductor device including an active device layer including a first surface extending in a horizontal direction and a second surface opposite to the first surface, and at least one first source/drain pattern and at least one second source/drain pattern, a first back end of line (BEOL) structure on the first surface and configured to supply electric power to the active device layer, a second BEOL structure on the second surface and configured to route a signal, an intermediate layer between the active device layer and the first BEOL structure, a plurality of insulating layers between the active device layer and the intermediate layer, at least one power via penetrating through the intermediate layer and at least a part of each insulating layer of the plurality of insulating layers in a vertical direction that is perpendicular to the horizontal direction, and the at least one power via electrically connected to the first BEOL structure and the active device layer, and at least one contact electrically connected to the active device layer and the second BEOL structure, wherein at least a part of a side surface of the at least one power via is in contact with the intermediate layer.

According to some example embodiments of the inventive concepts, there is provided a semiconductor device including an active device layer including a first surface extending in a horizontal direction and a second surface opposite to the first surface, and at least one first source/drain pattern and at least one second source/drain pattern, a first back end of line (BEOL) structure on the first surface and configured to supply electric power to the active device layer, a second BEOL structure on the second surface and configured to route a signal, an intermediate layer between the active device layer and the first BEOL structure, a plurality of insulating layers between the active device layer and the intermediate layer, and at least one power via penetrating through the intermediate layer and at least a part of each insulating layer of the plurality of insulating layers in a vertical direction that is perpendicular to the horizontal direction, and the at least one power via electrically connected to the first BEOL structure and the active device layer, wherein the at least one first source/drain pattern and the at least one second source/drain pattern are each spaced apart from each other in the horizontal direction, a plurality of channel layers and a plurality of first gate structures are alternately arranged in the vertical direction between the first source/drain pattern and the second source/drain pattern that are adjacent to each other, a plurality of second gate structures are on a channel layer at the uppermost end of the plurality of channel layers, at least one contact electrically connected to the at least one second source/drain pattern and the second BEOL structure, at least one second contact electrically connected to the plurality of second gate structures and the second BEOL structure, at least a part of a side surface of the at least one power via is in contact with the intermediate layer, and the at least one power via includes a first portion having a trapezoidal shape in a vertical section and a second portion having a round shape protruding toward the at least one first source/drain pattern.

At least some of the above and other features of the invention are set out in the claims.

### BRIEF DESCRIPTION OF THE DRAWINGS

Example embodiments of the inventive concepts will be more clearly understood from the following detailed description taken in conjunction with the accompanying drawings in which:
FIG. 1 is a cross-sectional view of a semiconductor device according to some example embodiments of the inventive concepts;
FIG. 2 is a cross-sectional view of a semiconductor device according to some example embodiments of the inventive concepts;
FIG. 3 is a cross-sectional view of a semiconductor device according to some example embodiments of the inventive concepts;
FIG. 4 is a cross-sectional view of a semiconductor device according to some example embodiments of the inventive concepts;
FIG. 5 is a flowchart illustrating a method of forming a semiconductor device, according to some example embodiments of the inventive concepts;
FIGS. 6A to 6J are cross-sectional views for describing a method of manufacturing a semiconductor device, according to some example embodiments of the inventive concepts; and
FIGS. 7A to 7E are cross-sectional views for describing a method of manufacturing a semiconductor device, according to some example embodiments of the inventive concepts.

### DETAILED DESCRIPTION

Hereinafter, some example embodiments will be described in detail with reference to accompanying drawings. Like reference numerals denote the same elements on the drawings, and detailed descriptions thereof are omitted.

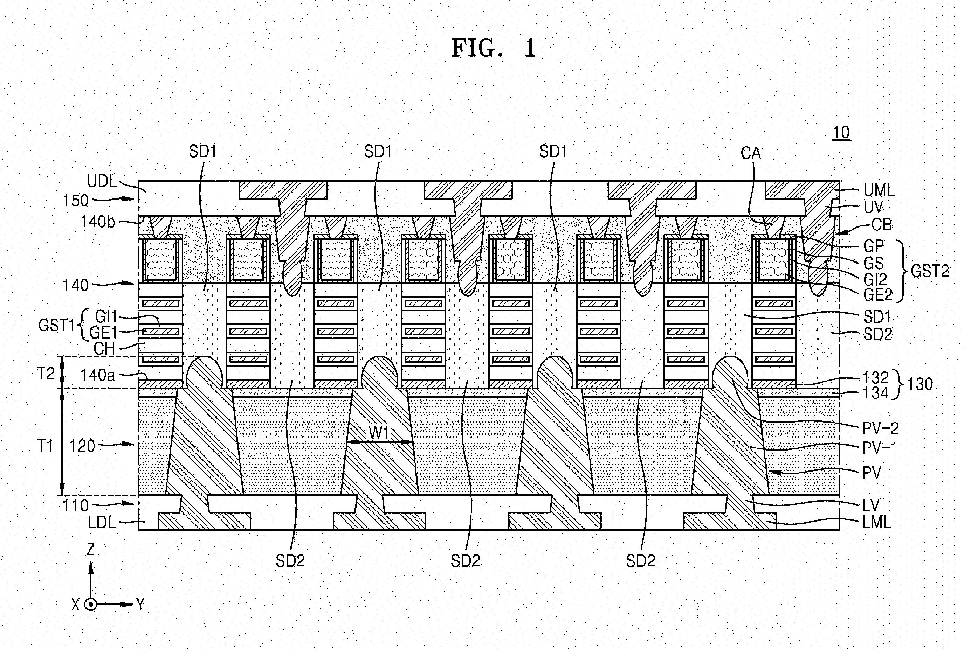

FIG. 1 is a cross-sectional view of a semiconductor device 10 according to some example embodiments of the inventive concepts.

Referring to FIG. 1, the semiconductor device 10 may include a first back end of line (BEOL) structure 110, an intermediate layer 120, an insulating layer 130, an active device layer 140, a second BEOL structure 150, and a power via PV. A back end of line (BEOL) structure may be a connection structure for providing electrical connection to/from the active device layer 140.

The first BEOL structure 110 may be formed to supply electric power. For example, the first BEOL structure 110 may transfer the electric power to the active device layer 140. For example, the first BEOL structure 110 may include a power distribution structure supplying the electric power on a first surface 140a of the active device layer 140. The power distribution structure may include an integrated circuit including a power distribution network (PDN) for power distribution.

The first BEOL structure 110 may include a lower insulating layer LDL, a plurality of lower distribution lines LML extending in a horizontal direction (X direction and/or Y direction), and a plurality of lower vias LV extending in a vertical direction (Z direction). The plurality of lower distribution lines LML may be at different vertical levels. For example, the plurality of lower vias LV may electrically connect different lower distribution lines LML. For example, the plurality of lower vias LV may electrically connect the lower distribution lines LML to the power via PV.

The lower insulating layer LDL may include an insulating material. For example, the lower insulating layer LDL may include silicon oxide, silicon nitride, silicon oxynitride, aluminum oxide, and/or titanium oxide.

The plurality of lower distribution lines LML and the plurality of lower vias LV may each include a conductive material including copper (Cu), gold (Au), silver (Ag), nickel (Ni), tungsten (W), aluminum (Al), or a combination thereof.

As used herein, a direction parallel to the upper surface or the lower surface of the intermediate layer 120 may be defined as a horizontal direction (X direction and/or Y direction), and a direction perpendicular to the upper surface or the lower surface of the intermediate layer 120 may be defined as a vertical direction (Z direction). The vertical direction may define a height direction. Accordingly, features that are further along the vertical direction than other features may be considered above the other features. Similarly, features that are less far along the vertical direction than other features may be considered below the other features. Upper features may be further along the vertical direction than lower features. It will be appreciated that the directions referenced herein are relative to the structure of the semiconductor device. Accordingly, the directions need not imply any particular orientation of the semiconductor device during use.

Although not shown in the drawings, the plurality of lower distribution lines LML and the plurality of lower vias LV may each further include a barrier material for preventing the conductive material from being dispersed out of the plurality of lower distribution lines LML and the plurality of lower vias LV. The barrier material may include, for example, titanium (Ti), tantalum (Ta), titanium nitride (TiN), tantalum nitride (TaN), or a combination thereof. Each of the plurality of lower distribution lines LML and the plurality of lower vias LV in the first BEOL structure 110 may be configured to transfer the electric power to the active device in the active device layer 140.

The intermediate layer 120 may be between the first BEOL structure 110 and the insulating layer 130. The intermediate layer 120 may improve the electric stability of the power via PV by surrounding a part of the side surface of the power via PV. For example, the intermediate layer 120 may be in contact or direct contact with at least a part of the side surface of the power via PV.

For example, the intermediate layer 120 may include an oxide material and/or a nitride material. For example, the intermediate layer 120 may include a material that is different from that of the lower insulating layer LDL. In another example embodiment, the intermediate layer 120 may include the same material as that of the lower insulating layer LDL.

The power via PV may transfer the electric power supplied from the first BEOL structure 110 to the active device layer 140. The power via PV may be formed through at least a part of the intermediate layer 120 in the vertical direction (Z direction). The power via PV may be electrically connected to the first BEOL structure 110 and the active device layer 140.

For example, the power via PV may include a conductive material to transfer an electrical signal. For example, the power via PV may be in contact or direct contact with a first source/drain pattern SD1 and transfer the electric power to the first source/drain pattern SD1. Also, the power via PV may not be in contact or direct contact with a second source/drain pattern SD2.

The power via PV may overlap the first source/drain pattern SD1 of the active device layer 140 in the vertical direction (Z direction) and may not overlap the second source/drain pattern SD2 in the vertical direction (Z direction). That is, in a plan view, the power via PV may be spaced apart from the second source/drain pattern SD2 in the horizontal direction (X direction and/or Y direction).

A lower surface of the power via PV may be flat. The lower surface of the power via PV may be at the same vertical level as those of the lower surface of the intermediate layer 120 and the upper surface of the first BEOL structure 110. A part of the upper surface of the power via PV may protrude to the first source/drain pattern SD1. The upper surface of the power via PV may be in contact or direct contact with the insulating layer 130 and the first source/drain pattern SD 1.

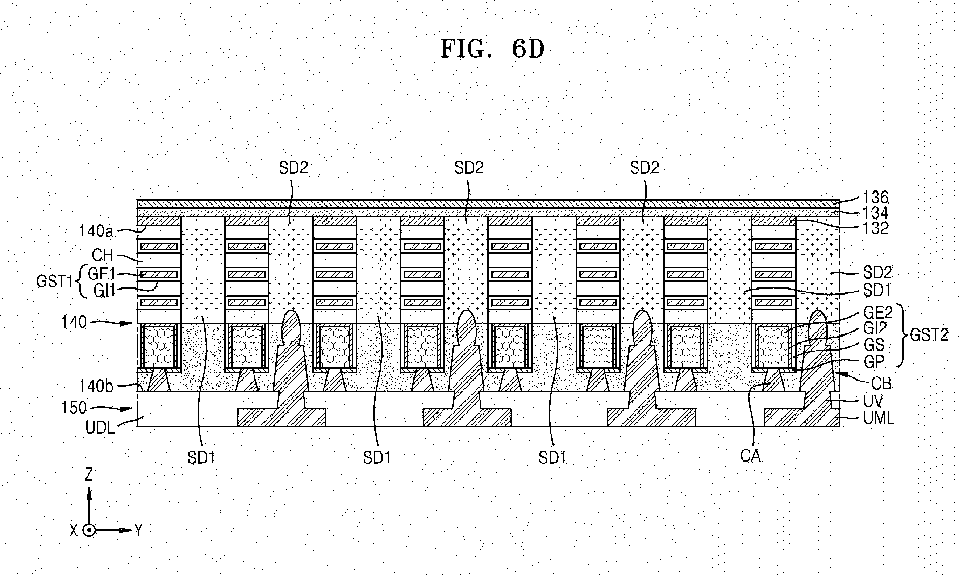

In the specification, except for FIGS. 6D to 7E, the upper surface of the first BEOL structure 110 may denote a surface contacting the intermediate layer 120, and the lower surface of the first BEOL structure 110 may be a surface opposite to the upper surface of the first BEOL structure 110. The upper surface of an element other than the first BEOL structure 110 may denote a surface that is farthest from the first BEOL structure 110 in the vertical direction (Z direction), and the lower surface of the above element may denote a surface opposite to the upper surface (e.g. closest to the first BEOL structure 110 in the vertical direction (Z direction)).

The power via PV may include a first portion PV-1 and a second portion PV-2. The first portion PV-1 may be formed at least partially through each of the intermediate layer 120 and the insulating layer 130 in the vertical direction (Z direction), and the second portion PV-2 may be formed at least partially through each of the insulating layer 130 and the first source/drain pattern SD1 in the vertical direction (Z direction). The first portion PV-1 and the second portion PV-2 are simply discriminated therebetween only for the convenience of description, and the first portion PV-1 and the second portion PV-2 may be formed of the same material and may be integrally coupled to each other. For example, the center axis of the first portion PV-1 may be aligned with the center axis of the second portion PV-2 in the power via PV in the vertical direction (Z direction). In another example embodiment, the center axis of the first portion PV-1 may be mis-aligned with the center axis of the second portion PV-2 in the power via PV in the vertical direction (Z direction). Also, at least one of the center axis of the first portion PV-1 and the center axis of the second portion PV-2 in the power via PV may be aligned with the center axis of the first source/drain pattern SD in the vertical direction (Z direction). In another example, at least one of the center axis of the first portion PV-1 and the center axis of the second portion PV-2 in the power via PV may be mis-aligned with the center axis of the first source/drain pattern SD in the vertical direction (Z direction).

The first portion PV-1 may have a trapezoidal shape in a vertical section. For example, in FIG. 1, the first portion PV-1 has a tapered shape that extends from the lower side to the upper side thereof while a horizontal width thereof is reduced. However, in some example embodiments, the first portion PV-1 may have a reverse-trapezoidal shape having the horizontal width reduced from the upper to the lower side thereof. However, one or more example embodiments are not limited to these examples, and the first portion PV-1 may have a rectangular shape, a circular shape, or an elliptical shape on the vertical section.

The lower surface of the first portion PV-1 may be at the same vertical level as that of the lower surface of the intermediate layer 120 and the upper surface of the first BEOL structure 110. Also, the upper surface of the first portion PV-1 may be in the insulating layer 130. For example, the first portion PV-1 may be at the same vertical level as that of a lower surface of a first insulating layer 132 and an upper surface of a second insulating layer 134. That is, the upper surface of the first portion PV-1 may be at the same vertical level as that of an interfacial layer between two different insulating layers in the insulating layer 130. Also, the side surface of the first portion PV-1 may be in contact with each of the second insulating layer 134 and the intermediate layer 120.

The second portion PV-2 may be connected to the first portion PV-1. For example, the lower surface of the second portion PV-2 may be at the same vertical level as that of the upper surface of the first portion PV-1, and the upper surface of the second portion PV-2 may have a round shape protruding toward the first source/drain pattern SD1. A sidewall of the second portion may contact or directly contact a portion of the insulating layer 130.

A first thickness T1, that is, a thickness of the first portion PV-1 in the vertical direction (Z direction), may range from about 10 nm to about 100 nm, and a second thickness T2, that is, a thickness of the second portion PV-2 in the vertical direction (Z direction), may range from about 1 nm to about 20 nm. Also, a first width W1 that is the horizontal width of the first portion PV-1 may range from about 10 nm to about 100 nm.

The insulating layer 130 may protect the first source/drain pattern SD1, the second source/drain pattern SD2, a first gate structure GST1, and/or a channel layer CH. The insulating layer 130 may be disposed between the intermediate layer 120 and the active device layer 140 and may include a plurality of layers including different materials. As described later, the insulating layer 130 may function as an etch stop layer when forming the first source/drain pattern SD1, the second source/drain pattern SD2, and the power via PV.

For example, the insulating layer 130 may include an oxide material and/or nitride material. For example, the insulating layer 130 may include the first insulating layer 132 and the second insulating layer 134. The first insulating layer 132 and the second insulating layer 134 may include different materials from each other. For example, the first insulating layer 132 and the second insulating layer 134 may each have a different etch selectivity from the other. For example, the intermediate layer 120 and the insulating layer 130 may include different materials.

The upper surface of the insulating layer 130, as well as the insulating layers 132, 134, and/or 136, may have an irregular shape. Additionally, the upper surface of the insulating layer 130 may have a concavo-convex shape. For example, the insulating layer 130 may have a concave or convex shape. The first insulating layers 132 may be spaced apart from each other in the horizontal direction (X direction and/or Y direction) with the first source/drain pattern SD1 and/or the second source/drain pattern SD2 therebetween. Also, the second insulating layers 134 may be spaced apart from each other in the horizontal direction (X direction and/or Y direction) with the power via PV therebetween. Because the upper surface of the insulating layer 130 may have a concavo-convex shape, the first surface 140a of the active device layer 140 may also have the concavo-convex shape (e.g. to align with the upper surface of the insulating layer 130). For example, the first surface 140a of the active device layer 140 may have a concave or convex shape.

The active device layer 140 is formed on the insulating layer 130, for example, the active device layer 140 may include a semiconductor material, e.g., a Group-IV semiconductor material, a Group III-V semiconductor material, a Group II-VI semiconductor material, or a combination thereof. The group IV semiconductor material may include, for example, silicon (Si), germanium (Ge), or a combination thereof. The group III-V semiconductor material may include, for example, gallium arsenide (GaAs), indium phosphor (InP), indium arsenide (InAs), indium antimony (InSb), indium gallium arsenide (InGaAs), or a combination thereof. The group II-VI semiconductor material may include, for example, zinc telluride (ZnTe), cadmium sulfide (CdS), or a combination thereof. The active device layer 140 may include a first surface 140a and a second surface 140b spaced apart from each other in the vertical direction (Z direction).

The active device layer 140 may include the channel layer CH, the first source/drain pattern SD1, the second source/drain pattern SD2, the first gate structure GST1, and a second gate structure GST2. For example, the active device layer 140 may have a gate-all-around (GAA) field-effect transistor (FET) structure in which a plurality of channel layers CH are arranged between the adjacent first source/drain pattern SD1 and the second source/drain pattern SD2. However, one or more example embodiments are not limited to the example, and the semiconductor device 10 may have a planar FET structure and/or fin FET structure.

The first source/drain pattern SD1 and the second source/drain pattern SD2 may be alternately arranged to be spaced apart from each other in the horizontal direction (X direction and/or Y direction), under the active device layer 140. The channel layer CH and the first gate structure GST1 may be arranged between the adjacent first source/drain pattern SD1 and the second source/drain pattern SD2. For example, each of the first source/drain pattern SD1 and the second source/drain pattern SD2 may be a source or a drain.

The first source/drain pattern SD1 may be in contact or direct contact with the power via PV and the second source/drain pattern SD2 may be in contact or direct contact with a second contact CB. That is, the first source/drain pattern SD1 may be aligned with the power via PV in the vertical direction (Z direction) and may not be aligned with the second contact CB in the vertical direction (Z direction). Also, the second source/drain pattern SD2 may not be aligned with the power via PV in the vertical direction (Z direction) and may be aligned with the second contact CB in the vertical direction (Z direction).

For example, the lowermost surface of the first source/drain pattern SD1 and the lower surface of the second source/drain pattern SD2 may be at the same vertical level. For example, the lowermost surface of the first source/drain pattern SD1 and the lower surface of the second source/drain pattern SD2 may be located at a vertical level lower than the uppermost surface of the insulating layer 130. Also, the lowermost surface of the first source/drain pattern SD1 and the lower surface of the second source/drain pattern SD2 may be at the same vertical level as that of the upper surface of the first portion PV-1 of the power via PV. As described below, the first source/drain pattern SD1 and the second source/drain pattern SD2 may be simultaneously formed, and thus, the lowermost surface of the first source/drain pattern SD1 and the lower surface of the second source/drain pattern SD2 may be at the same vertical level.

For example, the lowermost surface of the first source/drain pattern SD1 and the lower surface of the second source/drain pattern SD2 may be respectively at the same levels as those of the lower surface of the first insulating layer 132 and the upper surface of the second insulating layer 134. That is, the second insulating layer 134 may be disposed between the lower surface of the second source/drain pattern SD2 and the intermediate layer 120. Therefore, the lower surface of the second source/drain pattern SD2 may be protected by the second insulating layer 134.

The first gate structure GST1 may include a first gate electrode GE1 and a first gate insulating layer GI1 surrounding upper, lower, and side surfaces of the first gate electrode GE1.

Each of the first gate structure GST1 and the channel layer CH is arranged between adjacent first source/drain pattern SD1 and second source/drain pattern SD2. That is, each adjacent pair of first source/drain pattern SD1 and second source/drain pattern SD2 may have a first gate structure GST1 and channel layer CH located therebetween. The gate structure GST1 and the channel layer CH may be alternately arranged in the vertical direction (Z direction). However, the lowermost first gate structure GST1 may be arranged to be spaced apart from the insulating layer 130 in the vertical direction (Z direction). That is, the channel layer CH may be disposed between the lowermost first gate structure GST1 and the insulating layer 130.

The second gate structure GST2 may be formed on the uppermost channel layer CH. The second gate structure GST2 may include a second gate electrode GE2, a second gate insulating layer GI2, a gate spacer GS, and a gate capping pattern GP.

The second gate insulating layer GI2 may surround side and lower surfaces of the second gate electrode GE2 and the gate spacer GS may surround a side surface of the second gate insulating layer GI2. The gate capping pattern GP may be formed on an upper surface of the gate spacer GS, an upper surface of the second gate insulating layer GI2, and an upper surface of the second gate electrode GE2.

For example, each of the first gate electrode GE1 and the second gate electrode GE2 may be formed of polycrystalline silicon or a conductive material formed on polycrystalline silicon by doping a metal material such as aluminum (Al), nickel (Ni), tungsten (W), titanium (Ti), tantalum (Ta), etc. or a combination thereof. Also, the first gate electrode GE1 and the second gate electrode GE2 may be each formed of metal. For example, each of the first gate electrode GE1 and the second gate electrode GE2 may be formed of titanium nitride (TiN), tantalum nitride (TaN), titanium carbide (TiC), tantalum carbide (TaC), etc. or a combination thereof. The first gate electrode GE1 and the second gate electrode GE2 may be each formed to have a single layer or multi-layered structure.

For example, the first gate insulating layer GI1 and the second gate insulating layer GI2 may include a high-k material. For example, the high-k material may include at least one selected from aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). A high-k material may be a material that has a dielectric constant that his higher than that of silicon dioxide.

For example, the gate spacer GS may include at least one selected from SiCN, SiCON, and SiN. In another example, the gate spacer GS may include multi-layers including at least two selected from SiCN, SiCON, and SiN. For example, the gate capping pattern GP may include at least one selected from SiCN, SiCON, and SiN.

The second BEOL structure 150 may be disposed on the active device layer 140 (e.g. on the second surface 140b of the active device layer 140). The second BEOL structure 150 may be configured to route a signal. For example, the second BEOL structure 150 may process a signal transferred through the first source/drain pattern SD1 and the second BEOL structure 150.

The second BEOL structure 150 may include an upper insulating layer UDL, a plurality of upper distribution lines UML extending in the horizontal direction (X direction and/or Y direction), and a plurality of upper vias UV extending in the vertical direction (Z direction). The plurality of upper distribution lines UML may be disposed on different vertical levels. For example, the plurality of upper vias UV may be electrically connected to different upper distribution lines UML. For example, the plurality of upper vias UV may electrically connect the upper distribution lines UML to a first contact CA and the second contact CB.

The upper insulating layer UDL may include an insulating material. For example, the upper insulating layer UDL may include silicon oxide, silicon nitride, silicon oxynitride, aluminum oxide, and/or titanium oxide.

The plurality of upper distribution lines UML and the plurality of upper vias UV may each include a conductive material including copper (Cu), gold (Au), silver (Ag), nickel (Ni), tungsten (W), aluminum (Al), or a combination thereof.

Although not shown in the drawings, the plurality of upper distribution lines UML and the plurality of upper vias UV may each further include a barrier material for preventing the conductive material from being dispersed out of the plurality of upper distribution lines UML and the plurality of upper vias UV. The barrier material may include, for example, tantalum (Ta), titanium nitride (TiN), tantalum nitride (TaN), or a combination thereof. Each of the plurality of upper distribution lines UML and the plurality of upper vias UV in the second BEOL structure 150 may be configured to transfer the electric power to the active device in the active device layer 140.

The semiconductor device 10 may further include the first contact CA and the second contact CB. The first contact CA and the second contact CB may electrically connect the active device layer 140 to the second BEOL structure 150. Also, the first contact CA and the second contact CB may transfer electrical signals between the active device layer 140 and the second BEOL structure 150. For example, each of the first contact CA and the second contact CB may be formed through at least a part of the active device layer 140 in the vertical direction (Z direction). The first contact CA may be formed by penetrating at least a part of the gate capping pattern GP in the vertical direction (Z direction). The second contact CB may be formed through at least a part of the second source/drain pattern SD2 in the vertical direction (Z direction).

The first contact CA may be in contact with the second gate electrode GE2 and the second contact CB may be in contact with the second source/drain pattern SD2. The first contact CA may electrically connect the upper distribution lines UML and/or the upper vias UV of the second BEOL structure 150 to the second gate electrode GE2. The second contact CB may electrically connect the upper distribution lines UML and/or the upper vias UV of the second BEOL structure 150 to the second source/drain pattern SD2.

For example, the semiconductor device 10 of FIG. 1 includes a plurality of insulating layers 130, and the first source/drain pattern SD1 and the second source/drain pattern SD2 may be simultaneously formed. Accordingly, as compared with the case in which the first source/drain pattern SD1 and the second source/drain pattern SD2 are formed in different processes, the processing cost of the semiconductor device 10 may be relatively low. Also, the first source/drain pattern SD1 and the power via PV may be easily aligned in the vertical direction (Z direction). Also, the size of the power via PV may be relatively increased, and the electric stability of the semiconductor device 10 may be improved.

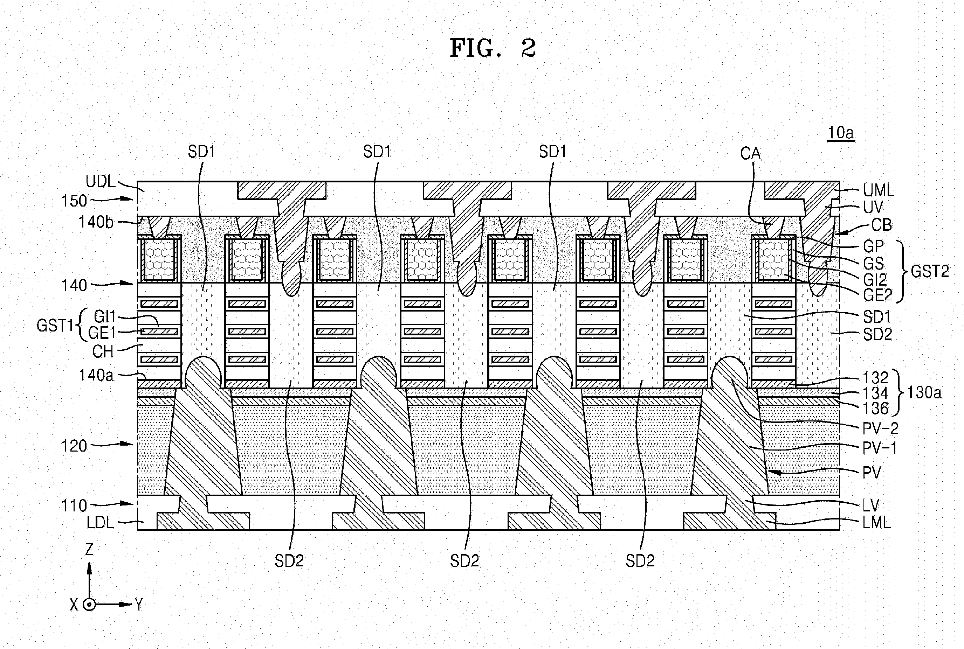

FIG. 2 is a cross-sectional view of a semiconductor device 10a according to some example embodiments of the inventive concepts.

Referring to FIG. 2, the semiconductor device 10a may include the first BEOL structure 110, the intermediate layer 120, an insulating layer 130a, the active device layer 140, the second BEOL structure 150, and the power via PV. The first BEOL structure 110, the intermediate layer 120, the active device layer 140, the second BEOL structure 150, and the power via PV of the semiconductor device 10a in FIG. 2 are substantially the same as the first BEOL structure 110, the intermediate layer 120, the active device layer 140, the second BEOL structure 150, and the power via PV of the semiconductor device 10 in FIG. 1, and thus, the insulating layer 130a is described below.

The insulating layer 130a may include first to third insulating layers 132, 134, and 136. For example, the first insulating layer 132 and the third insulating layer 136 may include the same material, and the second insulating layer 134 may include a material different from that of the first insulating layer 132 and the third insulating layer 136. For example, the first insulating layer 132 and the third insulating layer 136 may have the same etch selectivity, and the second insulating layer 134 may have an etch selectivity different from that of the first insulating layer 132 and the third insulating layer 136.

In another example embodiment, the first to third insulating layers 132, 134, and 136 may include different materials from each other. For example, the first to third insulating layers 132, 134, and 136 may each have different etch selectivities from one another.

The upper surface of the first portion PV-1 of the power via PV may be at the same vertical level as that of the lower surface of the first insulating layer 132 and the upper surface of the second insulating layer 134. Also, the side surface of the first portion PV-1 of the power via PV may be in contact with each of the second insulating layer 134, the third insulating layer 136, and the intermediate layer 120.

In FIG. 2, the insulating layer 130a includes the first to third insulating layers 132, 134, and 136, but one or more example embodiments are not limited thereto, and the number of insulating layers included in the insulating layer 130a is not limited thereto. For example, the insulating layer 130a may include four or more insulating layers. Also, each of the first insulating layer 132, the second insulating layer 134, and the third insulating layer 136 may include a plurality of insulating layers.

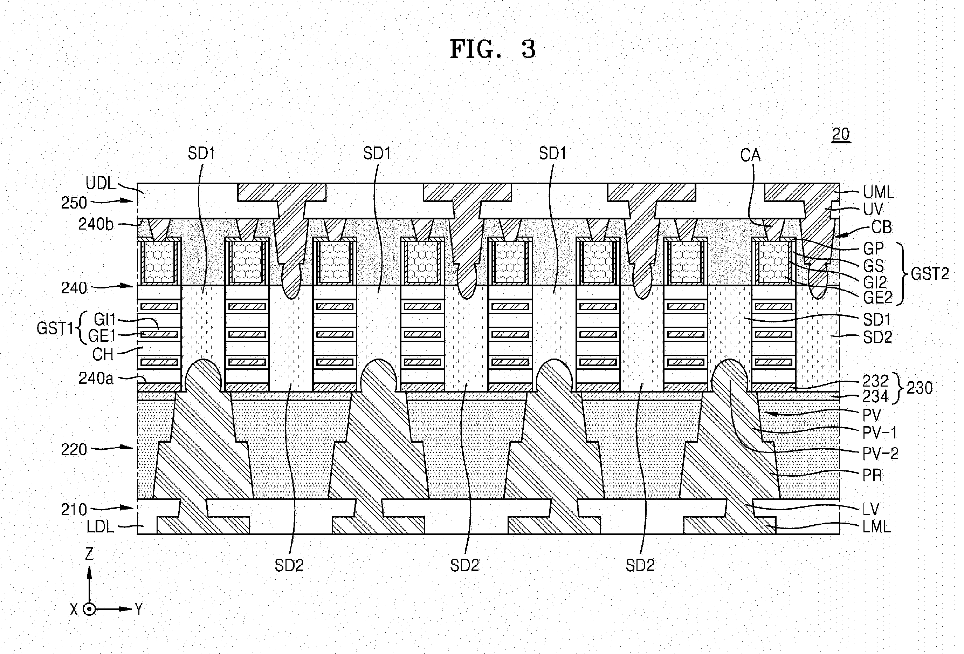

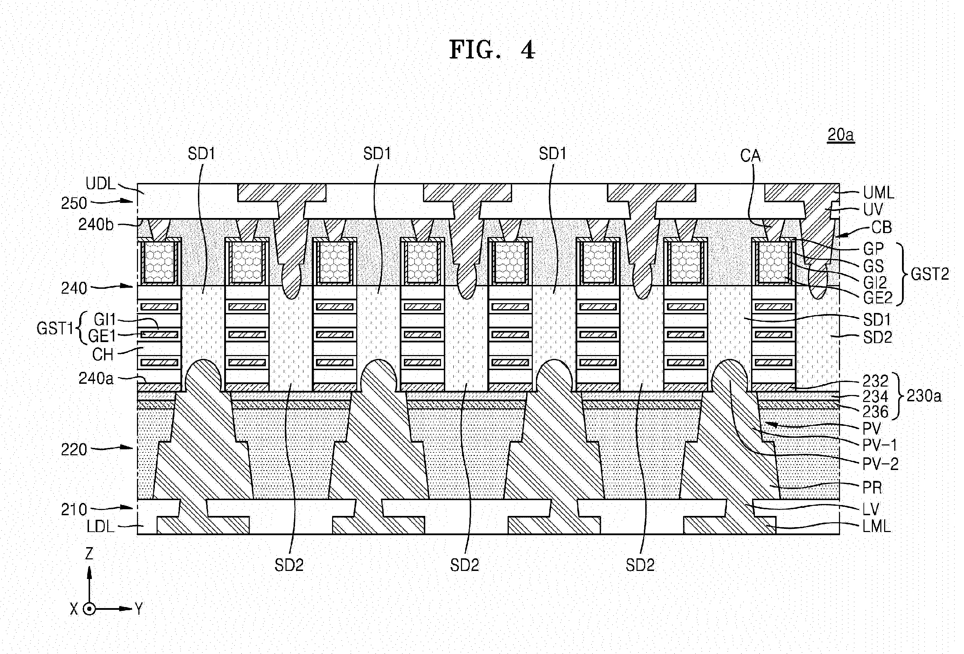

FIG. 3 is a cross-sectional view of a semiconductor device 20 according to some example embodiments of the inventive concepts. FIG. 4 is a cross-sectional view of a semiconductor device 20a according to some example embodiments of the inventive concepts.

Referring to FIG. 3, the semiconductor device 20 may include a first BEOL structure 210, an intermediate layer 220, an insulating layer 230, an active device layer 240, a second BEOL structure 250, the power via PV, and a power rail PR. Referring to FIG. 4, the semiconductor device 20a may include a first BEOL structure 210, an intermediate layer 220, an insulating layer 230a, an active device layer 240, a second BEOL structure 250, the power via PV, and a power rail PR.

The first BEOL structure 210, the intermediate layer 220, the insulating layer 230, the active device layer 240, the second BEOL structure 250, and the power via PV in the semiconductor device 20 of FIG. 3 may be substantially the same as the first BEOL structure 110, the intermediate layer 120, the insulating layer 130, the active device layer 140, the second BEOL structure 150, and the power via PV shown in FIG. 1. Also, the first BEOL structure 210, the intermediate layer 220, the insulating layer 230a, the active device layer 240, the second BEOL structure 250, and the power via PV in the semiconductor device 20a of FIG. 4 may be substantially the same as the first BEOL structure 110, the intermediate layer 120, the insulating layer 130a, the active device layer 140, the second BEOL structure 150, and the power via PV shown in FIG. 1. Therefore, the power rail PR is described in detail below.

Referring to FIG. 3 and FIG. 4, the power rail PR may be disposed between the power via PV and the first BEOL structure 210. For example, the power rail PR may be disposed between the power via PV and the plurality of lower distribution lines LML or between the power via PV and the plurality of lower vias LV.

When the semiconductor device 20 or 20a includes the power rail PR, the electrical resistance in the passage from the first BEOL structure 210 to the active device layer 240 may be reduced. When the power rail PR and the power via PV are arranged along with each other, the height of the power via PV may be reduced. Therefore, an aspect ratio of the power via PV is reduced, and the power via PV may be easily formed. Therefore, the electrical characteristics of the semiconductor device 20 or 20a may be improved.

The power rail PR may include a conductive material. For example, the power rail PR may include the same material as that of the power via PV. In another example embodiment, the power rail PR may include a material different from that of the power via PV. The power rail PR may have a horizontal width that is greater than that of the power via PV, but one or more example embodiments of the inventive concepts are not limited thereto.

The power rail PR may have a trapezoidal shape in a vertical section. In FIGS. 3 and 4, for example, the power rail PR has a tapered shape of which the horizontal width is reduced from the lower side toward the upper side thereof, but the power rail PR may have a reverse-trapezoidal shape of which the horizontal width is reduced from the upper side toward the lower side thereof. However, one or more example embodiments are not limited to the depicted example embodiments, and the power rail PR may have a rectangular shape, a circular shape, or an elliptical shape on the vertical section. Also, the power rail PR may be longer in the first horizontal direction (X direction) and/or second horizontal direction (Y direction) (e.g. relative to the vertical direction). For example, the power rail PR may be longer in a transverse or horizontal direction than in a vertical direction.

For example, the power rail PR may transfer a power voltage VDD to the active device layer 240. In another example embodiment, the power rail PR may transfer a ground voltage VSS to the active device layer 240.

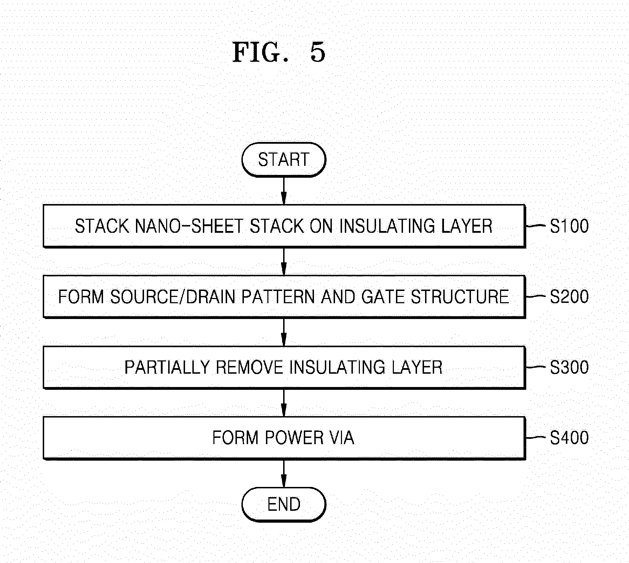

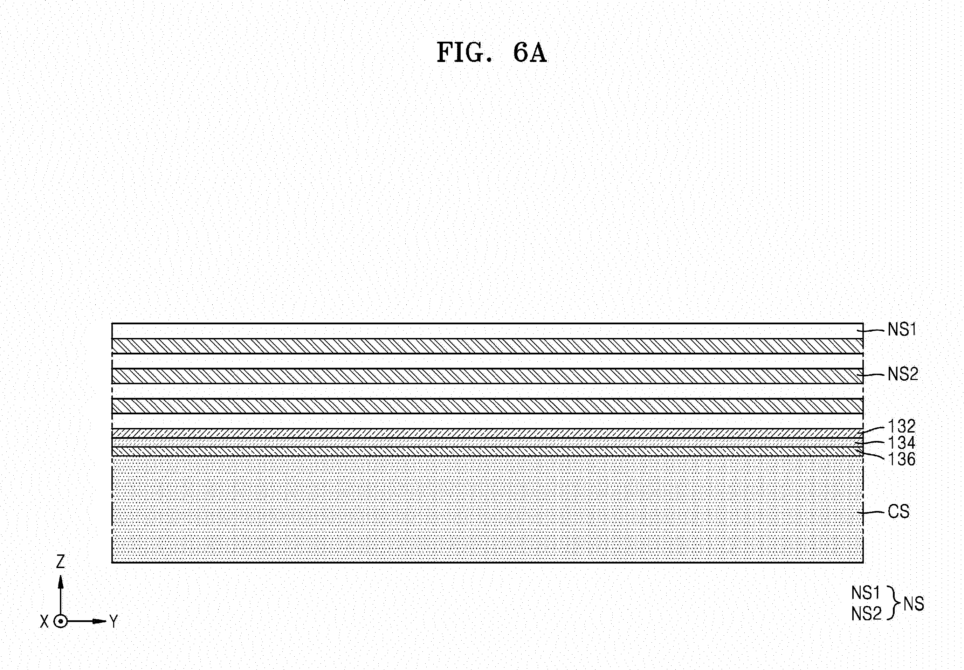

FIG. 5 is a flowchart illustrating a method of forming a semiconductor device, according to some example embodiments of the inventive concepts. FIGS. 6A to 6J are cross-sectional views for describing a method of manufacturing a semiconductor device, according to some example embodiments of the inventive concepts. The descriptions below may also be provided with reference to FIG. 1.

Referring to FIGS. 5 and 6A, the first insulating layer 132, the second insulating layer 134, and the third insulating layer 136 may be formed on a carrier substrate CS. For example, the carrier substrate CS may include silicon. Also, a nano-sheet stack NS may be stacked on the insulating layer 130 (S100). The nano-sheet stack NS may be formed by repeatedly stacking first and second nano-sheet layers NS 1 and NS2 alternately in the vertical direction (Z direction). For example, the first and second nano-sheet layers NS1 and NS2 may each include silicon (Si) and/or silicon germanium (SiGe). The first and second nano-sheet layers NS1 and NS2 may be substituted with the first source/drain pattern SD1, the second source/drain pattern SD2, and the channel layer CH. A nano-sheet layer may be a layer that has a thickness in a scale ranging from 1 to 100 nm.

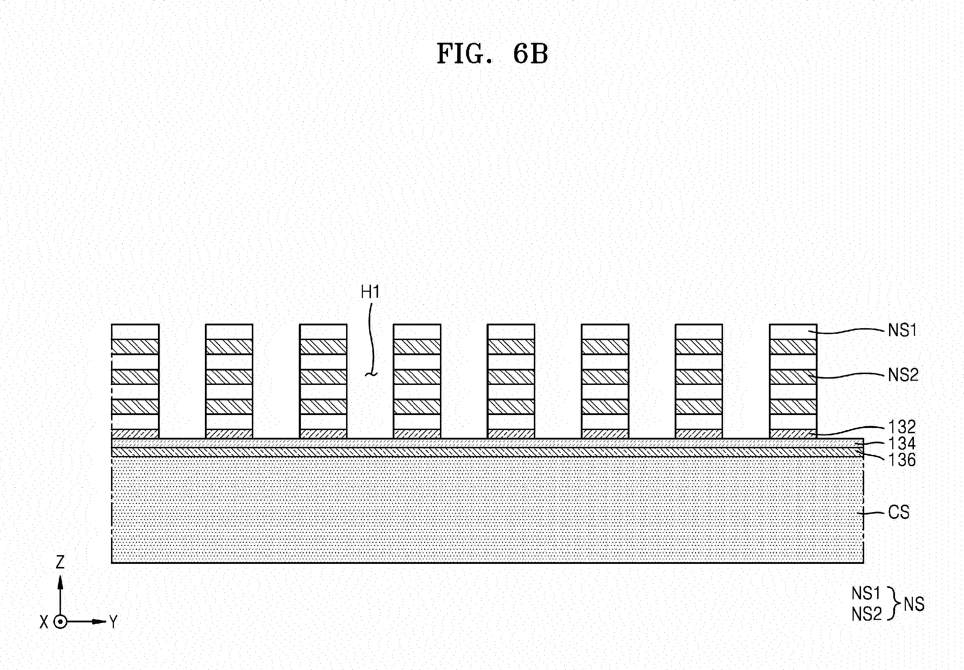

Referring to FIG. 6B, from the resultant of FIG. 6A, the first and second nano-sheet layers NS1 and NS2 are at least partially removed, and a plurality of first holes H1 may be formed. In the plurality of first holes H1, the first source/drain pattern SD1 and the second source/drain pattern SD2 may be formed later. In the process of forming the plurality of first holes H1, the first insulating layer 132 may be at least partially removed. For example, each of the plurality of first holes H1 may be formed by a dry etching and/or wet etching process.

For example, each of the plurality of first holes H1 in which the first source/drain pattern SD1 and the second source/drain pattern SD2 are to be formed may be simultaneously formed with the other. For example, the lower surface of each of the plurality of first holes H1 may be at the same vertical level as that of the lower surface of the first insulating layer 132 and the upper surface of the second insulating layer 134.

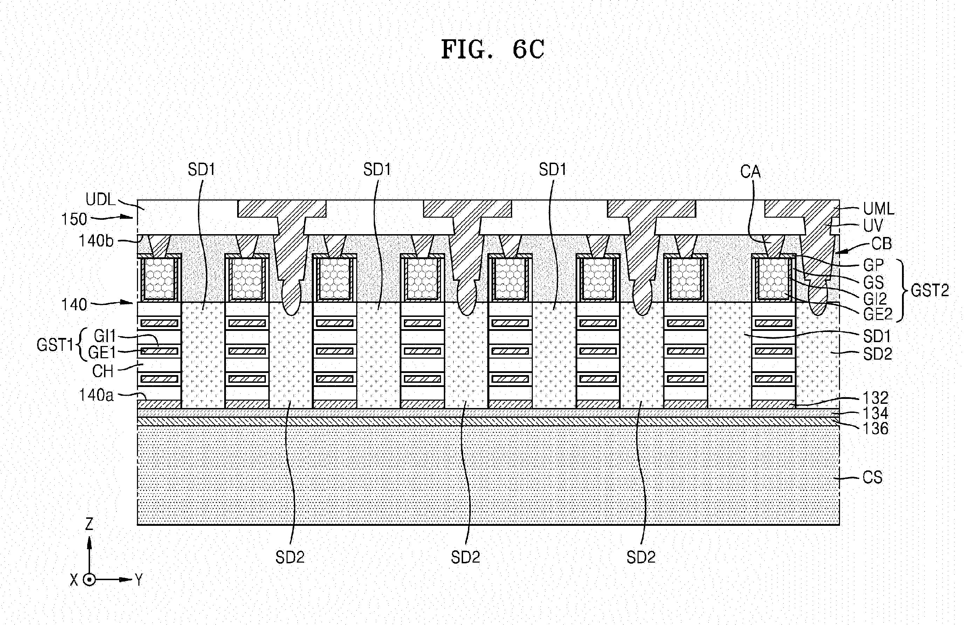

Referring to FIGS. 5 and 6C, the first source/drain pattern SD1, the second source/drain pattern SD2, the first gate structure GST1, the second gate structure GST2, the channel layer CH, the first contact CA, the second contact CB, and the second BEOL structure 150 may be formed on the resultant of FIG. 6B (S200). Although not shown in FIG. 6C, a support substrate (not shown) and a bonding layer (not shown) disposed between the support substrate and the second BEOL structure 150 and bonding the support substrate to the second BEOL structure 150 may be additionally formed on the second BEOL structure 150.

Referring to FIG. 6D, the resultant of FIG. 6C is turned over, and the carrier substrate CS (see FIG. 6C) is removed. For example, the carrier substrate CS may be removed by a chemical mechanical polishing (CMP), a wet etching, and/or a dry etching method.

In FIGS. 6D to 6J, the upper surface of the second BEOL structure 150 may be a surface contacting the active device layer 140, and the lower surface of the second BEOL structure 150 may be opposite to the upper surface of the second BEOL structure 150. The upper surface of the other components than the second BEOL structure 150 may denote a surface that is farthest from the lower surface of the second BEOL structure 150 in the vertical direction (Z direction), and the lower surface of the component may denote the surface opposite to the upper surface.

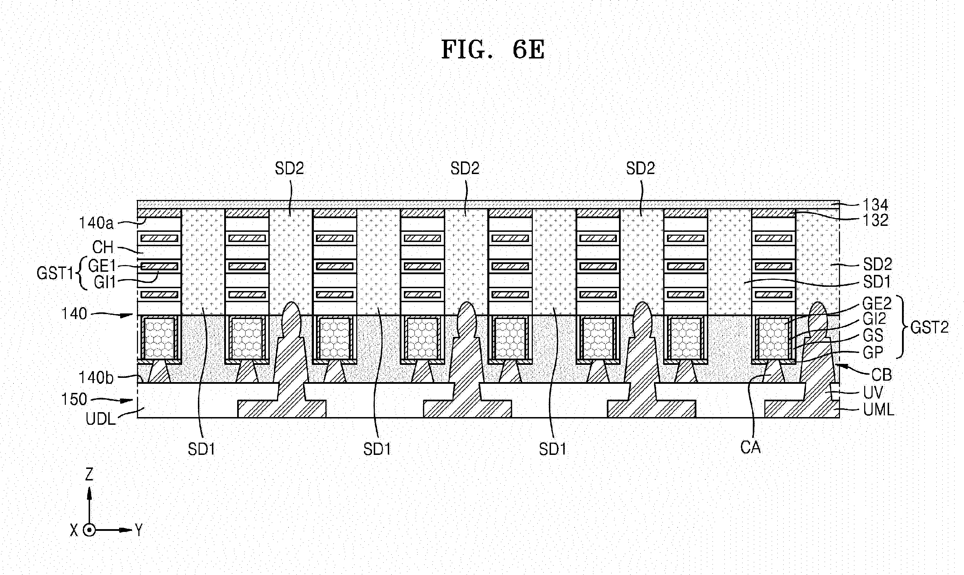

Referring to FIGS. 5 and 6E, at least one of the plurality of insulating layers may be removed from the resultant of FIG. 6D (S300). For example, the third insulating layer 136 (see FIG. 6D) may be removed. For example, the third insulating layer 136 (see FIG. 6D) may be removed by a wet etching and/or dry etching method.

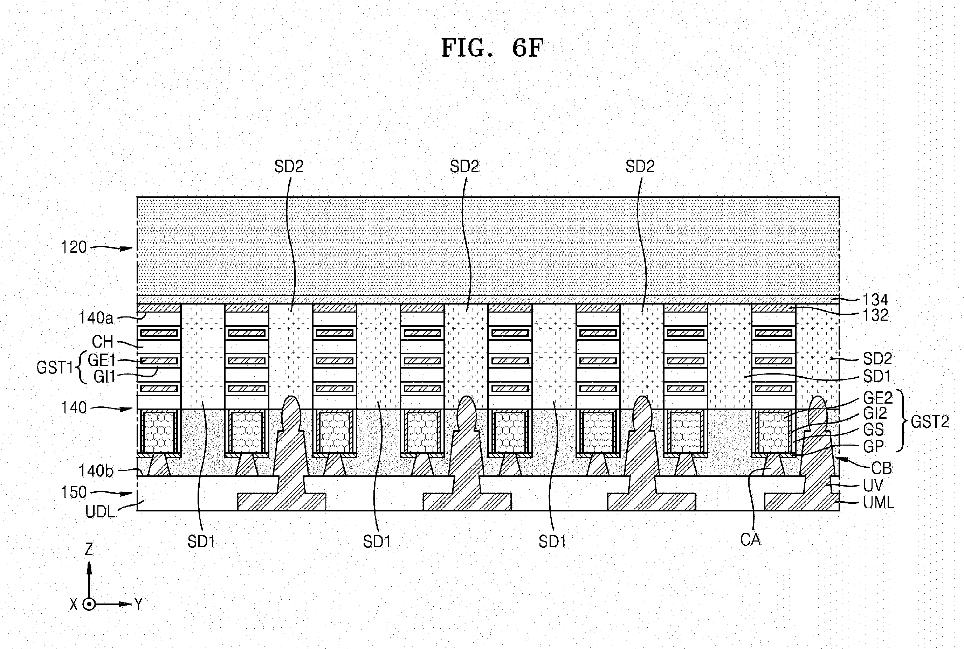

Referring to FIG. 6F, the intermediate layer 120 may be formed on the second insulating layer 134. For example, the intermediate layer 120 may include an oxide material. For example, the intermediate layer 120 may be deposited on the second insulating layer 134. The deposition of the intermediate layer 120 may be performed by a method selected from a physical vapor deposition (PVD), a chemical vapor deposition (CVD), and an atomic layer deposition (ALD).

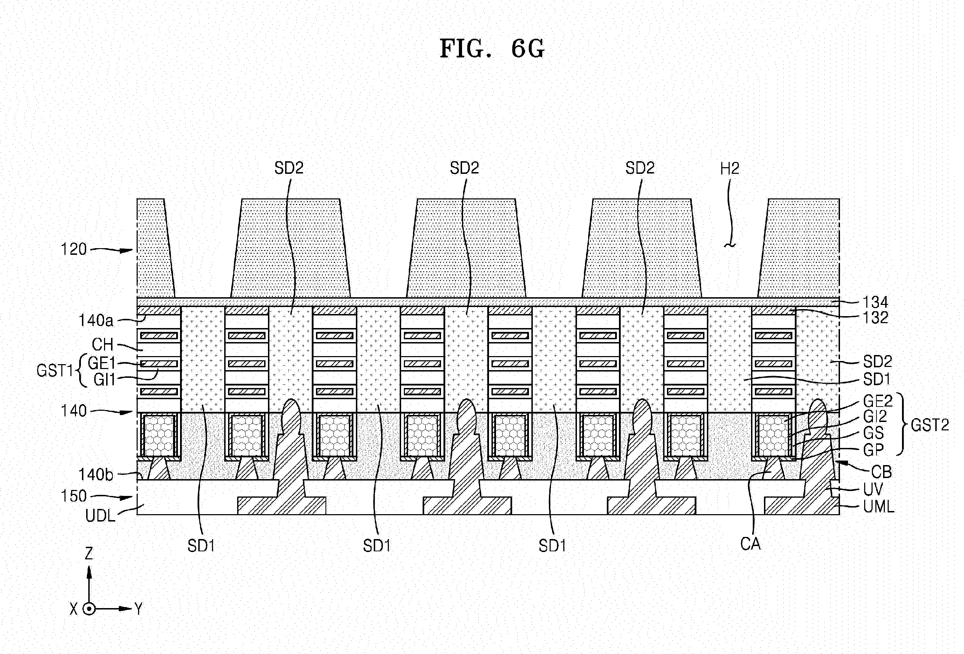

Referring to FIG. 6G, a plurality of second holes H2 penetrating at least a part of the intermediate layer 120 in the vertical direction (Z direction) may be formed. For example, each of the plurality of second holes H2 may be formed by a dry etching and/or wet etching process.

The power via PV may be partially formed in the plurality of second holes H2. Each of the plurality of second holes H2 may overlap one of the first source/drain patterns SD1 in the vertical direction (Z direction). Also, each of the plurality of second holes H2 may not overlap any of the second source/drain pattern SD2 in the vertical direction (Z direction).

During etching the intermediate layer 120, the second insulating layer 134 may function as an etch stop layer. A lower surface of each of the plurality of second holes H2 may be at the same vertical level as that of the upper surface of the second insulating layer 134.

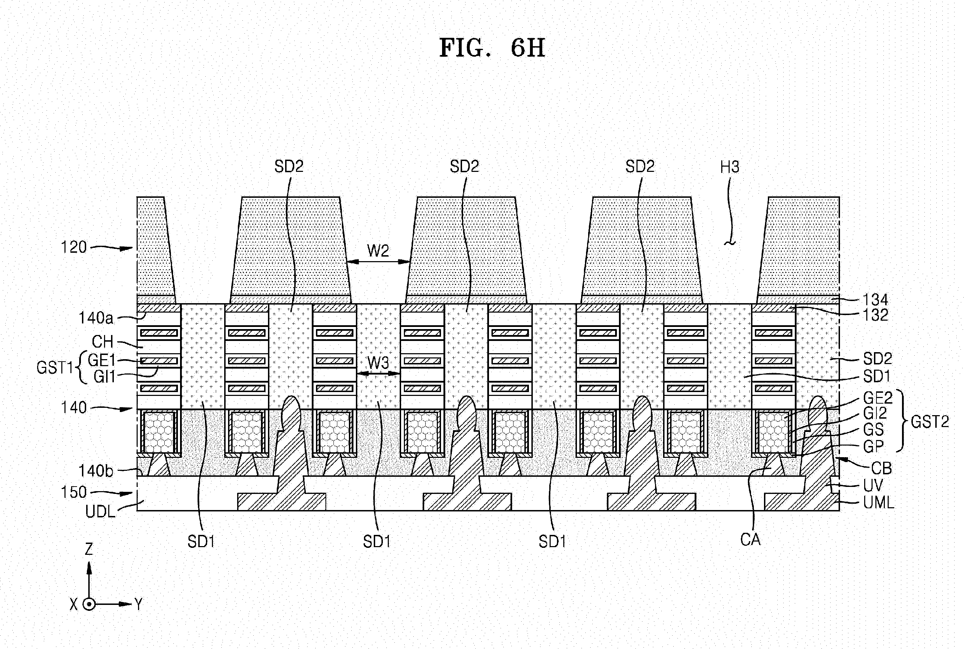

Referring to FIG. 6H, from the resultant of FIG. 6G, the second insulating layer 134 located under the plurality of second holes H2 is at least partially removed to form a plurality of third holes H3. For example, the second insulating layer 134 may be partially removed by a wet etching and/or dry etching method.

Each of the plurality of third holes H3 may be formed to expose the upper surface of the first source/drain pattern SD1. A lower surface of each of the plurality of third holes H3 may be at the same vertical level as that of the upper surface of the first source/drain pattern SD1, the upper surface of the second source/drain pattern SD2, the upper surface of the first insulating layer 132, and/or the lower surface of the second insulating layer 134.

Each of the plurality of third holes H3 may have a second width W2. Also, the first source/drain pattern SD1 may have a third width W3. The second width W2 may be greater than the third width W3. Also, for example, the second width W2 may be equal to the first width W1. Also, centers of the plurality of third holes H3 may be aligned with the centers of the first source/drain patterns SD1 in the vertical direction (Z direction). In another example, centers of the plurality of third holes H3 may be mis-aligned with the centers of the first source/drain patterns SD1 in the vertical direction (Z direction).

Therefore, the lower surfaces of the plurality of third holes H3 may be in contact with the upper surface of the first insulating layer 132 and the upper surface of the first source/drain pattern SD1. At least a part of the first insulating layer 132 contacting the lower surfaces of the third holes H3 may function as a kind of mask when forming a plurality of fourth holes H4 discussed in greater detail below.

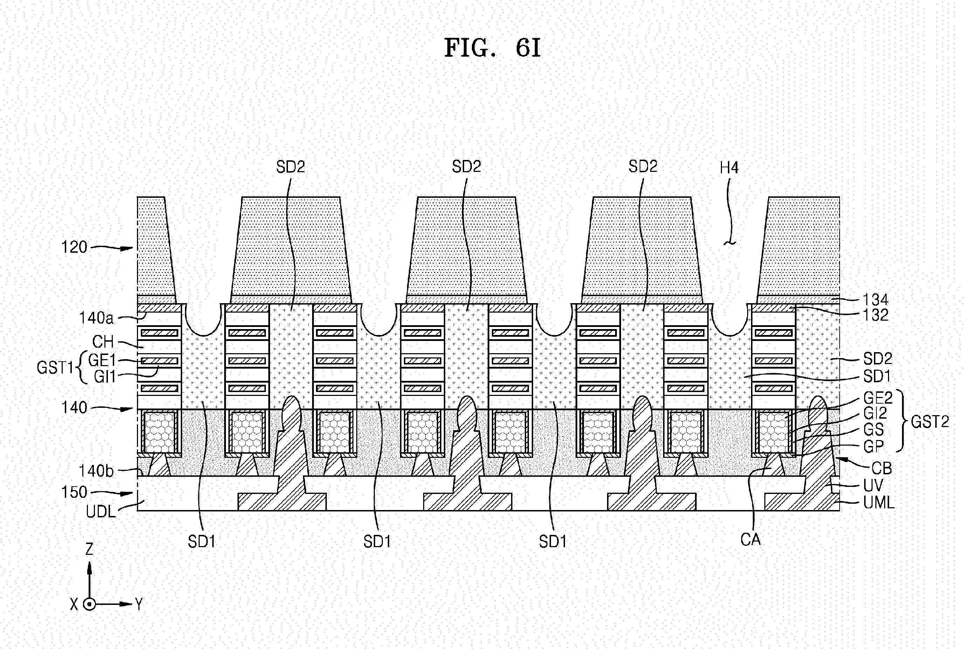

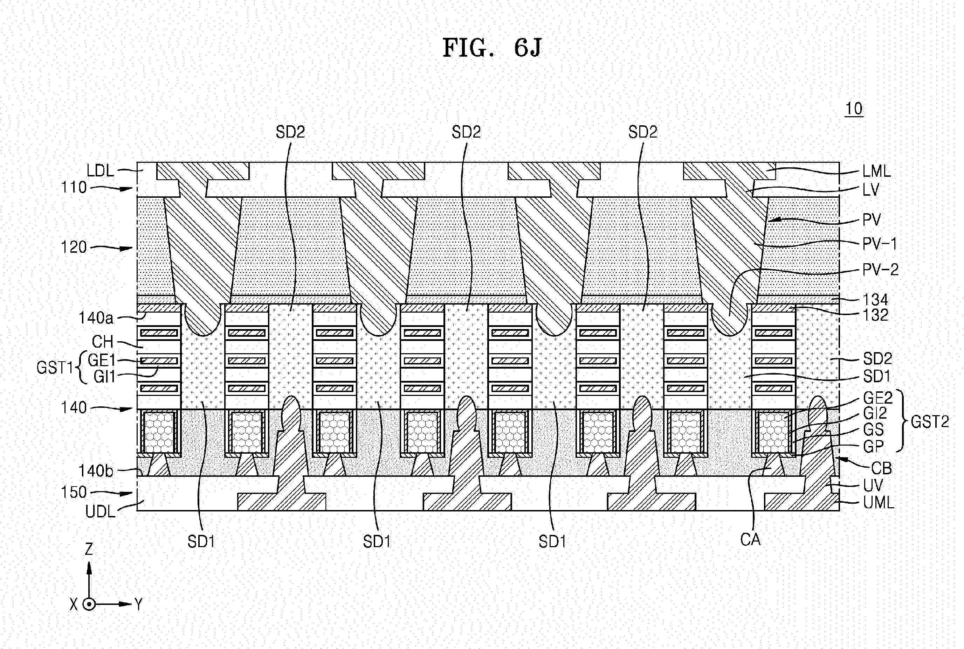

Referring to FIG. 6I, a plurality of fourth holes H4 may be formed in the resultant of FIG. 6H by using the first insulating layer 132 as a mask (e.g., hard mask). The plurality of fourth holes H4 may be formed in regions where the power vias PV are to be formed (See FIG. 6J). The upper region of the fourth hole H4 may have a trapezoidal shape, and a lower region of the fourth hole H4 may protrude downward in the vertical direction. In the upper region of the fourth hole H4, the first portion PV-1 of the power via PV may be formed later, and in the lower region of the fourth hole H4, the second portion PV-2 of the power via PV may be formed later. The lower region of the fourth hole H4 is formed by using the first insulating layer 132 as a mask, and thus, the width of the lower region of the fourth hole H4 may be less than that of the upper region of the fourth hole H4. That is, the width of the first portion PV-1 of the power via PV may be greater than that of the second portion PV-2 thereof.

Therefore, the lowermost surface of the fourth hole H4 may be at a vertical level lower than that of the upper surface of the first source/drain pattern SD1, the upper surface of the second source/drain pattern SD2, the upper surface of the first insulating layer 132, and the lower surface of the second insulating layer 134.

Referring to FIGS. 5 and 6J, a conductive material is filled in each of the plurality of fourth holes H4 so that the plurality of power vias PV may be formed (S400), and the first BEOL structure 110 may be formed on the intermediate layer 120. The first BEOL structure 110 may include the plurality of lower distribution lines LML and the plurality of lower vias LV.

The semiconductor device 10 according to the inventive concepts may include a plurality of insulating layers 130, and the first source/drain pattern SD1 and the second source/drain pattern SD2 may be simultaneously formed. In this case, as compared with the case in which the first source/drain pattern SD1 and the second source/drain pattern SD2 are respectively formed in separate processes, the processing cost of the semiconductor device 10 may be relatively low.

Also, according to the method of manufacturing the semiconductor device 10 of the inventive concept, the second insulating layer 134 may operate as an etch stop layer, and the plurality of second holes H2 may be easily formed. Also, according to the method of manufacturing according to the inventive concepts, the first to third insulating layers 132, 134, and 136 are formed, and thus, a carrier substrate CS may be easily removed while protecting the first source/drain pattern SD1 and the second source/drain pattern SD2. Also, according to the method of manufacturing the semiconductor device 10 according to the inventive concepts, in the process of forming the plurality of fourth holes H4, the first insulating layer 132 may act as a mask, and thus, the first source/drain pattern SD1 and the power via PV may be easily aligned in the vertical direction (Z direction). Also, the size of the power via PV may be relatively increased, and the electric stability of the semiconductor device 10 may be improved.

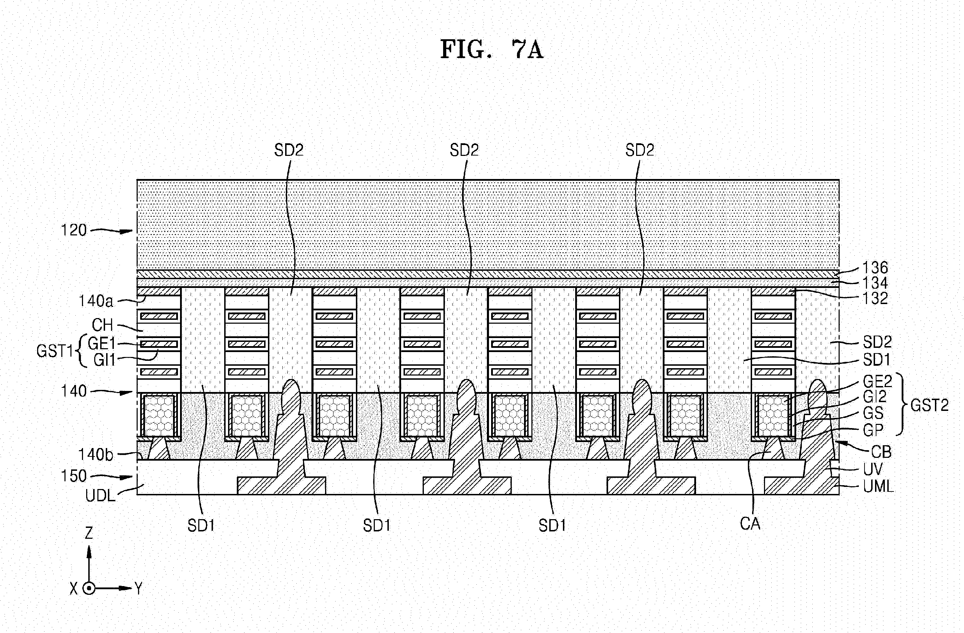

FIGS. 7A to 7E are cross-sectional views for describing a method of manufacturing a semiconductor device, according to some example embodiments of the inventive concepts. The descriptions are provided also with reference to FIGS. 2 and 5.

Referring to FIG. 7A, after the process of FIG. 6C, the intermediate layer 120 may be formed on the third insulating layer 136. For example, the intermediate layer 120 may include an oxide material and/or a nitride material.

In FIGS. 7A to 7E, the upper surface of the second BEOL structure 150 may be a surface contacting the active device layer 140, and the lower surface of the second BEOL structure 150 may be opposite to the upper surface of the second BEOL structure 150. The upper surface of the other components than the second BEOL structure 150 may denote a surface that is farthest from the lower surface of the second BEOL structure 150 in the vertical direction (Z direction), and the lower surface of the component may denote the surface opposite to the upper surface.

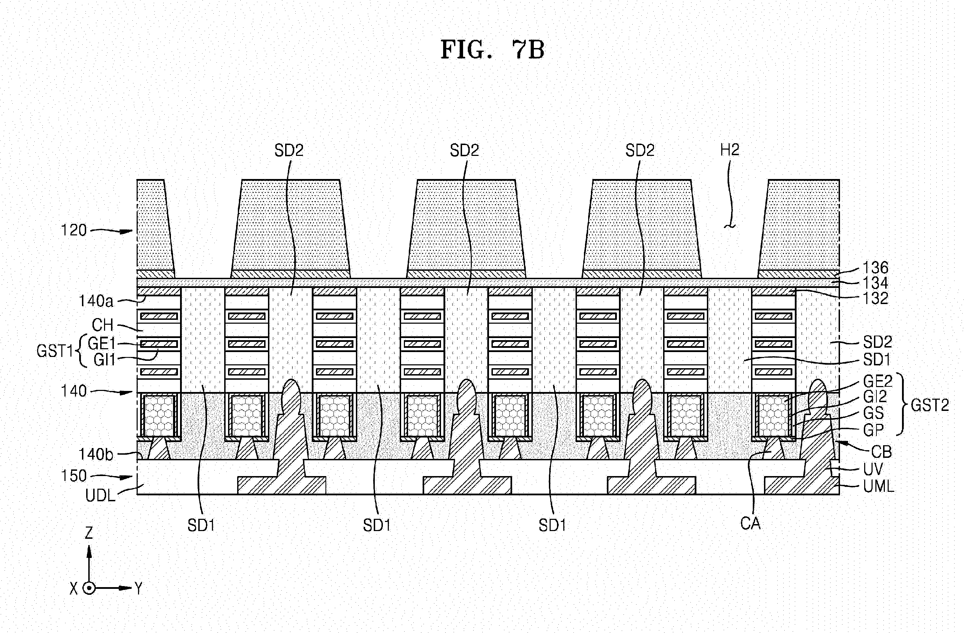

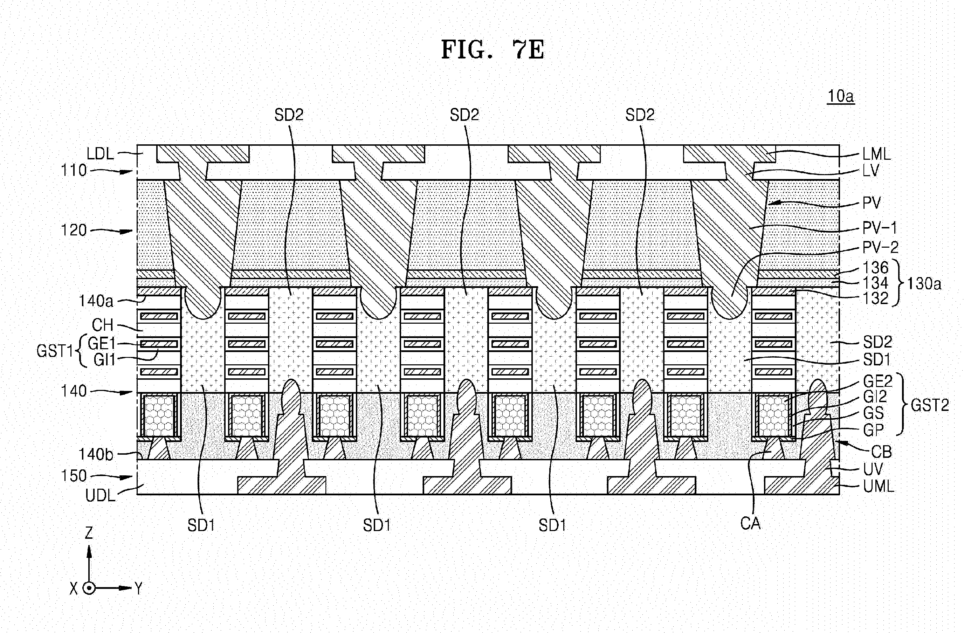

Referring to FIG. 7B, in the resultant of FIG. 7A, a plurality of second holes H2 penetrating at least a part of the intermediate layer 120 in the vertical direction (Z direction) may be formed. For example, each of the plurality of second holes H2 may be formed by a dry etching and/or wet etching process. The power via PV may be partially formed in the plurality of second holes H2 (See FIG. 7E). Each of the plurality of second holes H2 may overlap one of the first source/drain patterns SD1 in the vertical direction (Z direction). Also, each of the plurality of second holes H2 may not overlap any of the second source/drain pattern SD2 in the vertical direction (Z direction).

During etching the intermediate layer 120, the second insulating layer 134 may function as an etch stop layer. A lower surface of each of the plurality of second holes H2 may be at the same vertical level as that of the upper surface of the second insulating layer 134. For example, the lower surface of each of the plurality of second holes H2 may be at the same vertical level as that of the upper surface of the second insulating layer 134 and the lower surface of the third insulating layer 136.

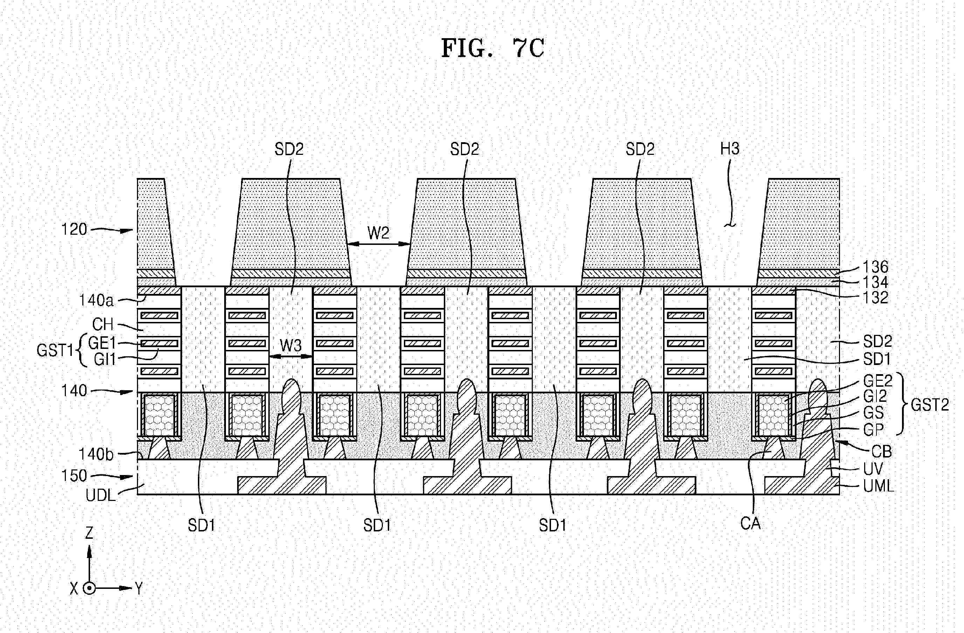

Referring to FIG. 7C, from the resultant of FIG. 7B, the second insulating layer 134 located under the plurality of second holes H2 is at least partially removed to form a plurality of third holes H3. For example, the second insulating layer 134 may be at least partially removed by a wet etching and/or dry etching method.

A lower surface of each of the plurality of third holes H3 may be at the same vertical level as that of the upper surface of the first source/drain pattern SD1, the upper surface of the second source/drain pattern SD2, the upper surface of the first insulating layer 132, and/or the lower surface of the second insulating layer 134.

Each of the plurality of third holes H3 may have a second width W2. Also, the first source/drain pattern SD1 may have a third width W3. The second width W2 may be greater than the third width W3. Also, for example, the second width W2 may be equal to the first width W1. Also, centers of the plurality of third holes H3 may be aligned with the centers of the first source/drain patterns SD1 in the vertical direction (Z direction). In another example, centers of the plurality of third holes H3 may be mis-aligned with the centers of the first source/drain patterns SD1 in the vertical direction (Z direction).

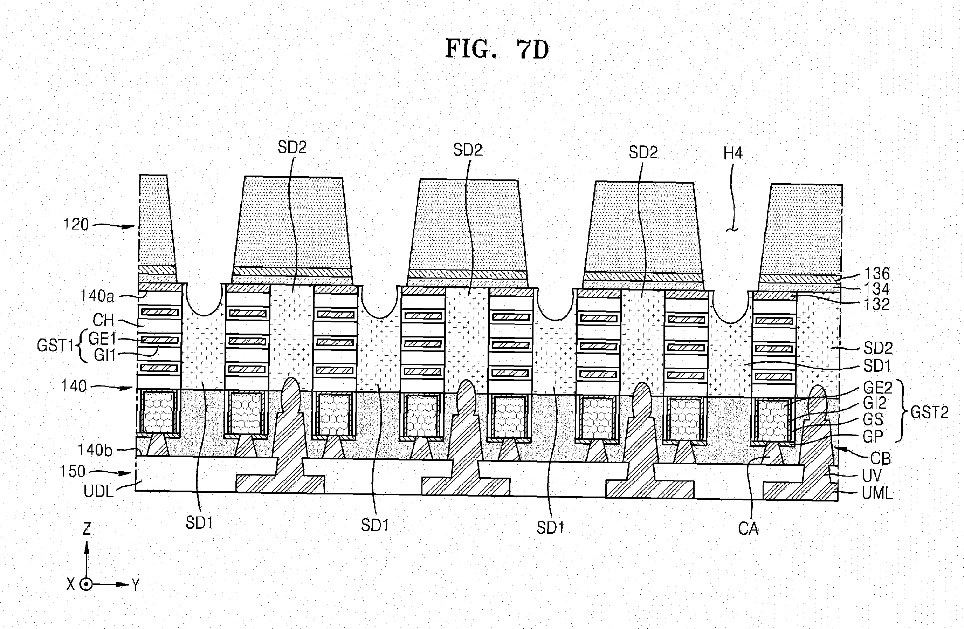

Therefore, the lower surfaces of the plurality of third holes H3 may be in contact with the upper surface of the first insulating layer 132 and the upper surface of the first source/drain pattern SD1. The upper surface of the first insulating layer 132 coming into contact with the lower surface of the third hole H3 may function as a mask when forming a plurality of fourth holes H4 (see FIG. 7D) later.

Referring to FIG. 7D, a plurality of fourth holes H4 may be formed in the resultant of FIG. 7C by using the first insulating layer 132 as a mask (e.g., hard mask). The plurality of fourth holes H4 may be formed in regions where the power vias PV are to be formed. The upper region of the fourth hole H4 may have a trapezoidal shape, and a lower region of the fourth hole H4 may protrude downward in the vertical direction. Therefore, a lowermost point of the fourth hole H4 may be at a vertical level lower than each of the uppermost surface of the first source/drain pattern SD1, the upper surface of the second source/drain pattern SD2, the upper surface of the first insulating layer 132, and the lower surface of the second insulating layer 134.

In the upper region of the fourth hole H4, the first portion PV-1 of the power via PV may be formed later, and in the lower region of the fourth hole H4, the second portion PV-2 of the power via PV may be formed later. The lower region of the fourth hole H4 is formed by using the first insulating layer 132 as a mask, and thus, the width of the lower region of the fourth hole H4 may be less than that of the upper region of the fourth hole H4. That is, the width of the first portion PV-1 of the power via PV may be greater than that of the second portion PV-2 thereof.

Referring to FIGS. 5 and 7E, a conductive material is formed in each of the plurality of fourth holes H4 so that the plurality of power vias PV may be formed (S400), and the first BEOL structure 110 may be formed on the intermediate layer 120.

The processes of manufacturing the semiconductor device 10a shown in FIG. 2, which are described above with reference to FIGS. 7A to 7E, may be substantially the same as the manufacturing processes of the semiconductor device 10 of FIG. 1 described above with reference to FIGS. 6A to 6J, except that the process of removing the third insulating layer 136 is omitted.

A method of manufacturing an example embodiment of the semiconductor device 10 as depicted in FIG. 1 is described with reference to FIGS. 6A to 6J, and a method of manufacturing an example embodiment of the semiconductor device 10a as depicted in FIG. 2 is described with reference to FIGS. 7A to 7E. However, one of ordinary skill in the art would appreciate that the semiconductor devices 20 and 20a described above with reference to FIGS. 3 and 4 and variously transformed and modified image sensors therefrom may be manufactured within the scope of the inventive concepts by applying various transformations and modifications within the scope of the inventive concepts.

While the inventive concepts have been particularly shown and described with reference to example embodiments thereof, it will be understood that various changes in form and details may be made therein without departing from the scope of inventive concepts as defined in the following claims.

Embodiments are set out in the following clauses:
1. A semiconductor device comprising:
   an active device layer including a plurality of source/drain patterns;
   a plurality of insulating layers on the active device layer;
   a back end of line (BEOL) structure on the plurality of insulating layers and configured to supply electric power to the active device layer;
   an intermediate layer between the plurality of insulating layers and the BEOL structure; and
   at least one power via penetrating through the intermediate layer and at least a part of each insulating layer of the plurality of insulating layers in a vertical direction, and the at least one power via electrically connected to the BEOL structure and the active device layer,
   wherein at least a part of a side surface of the at least one power via is in contact with the intermediate layer.
2. The semiconductor device of clause 1, wherein at least two of the plurality of insulating layers have different etch selectivities.
3. The semiconductor device of clause 1 or clause 2, wherein
   upper surfaces of the plurality of insulating layers have concave or convex shapes, and
   an uppermost surface of the plurality of insulating layers is at a vertical level that is higher than a lowermost surface of the plurality of source/drain patterns.
4. The semiconductor device of any preceding clause, wherein at least a part of a side surface of the at least one power via is in contact with the plurality of insulating layers.
5. The semiconductor device of any preceding clause, wherein
   the plurality of source/drain patterns are spaced apart from each other in a horizontal direction that is perpendicular to the vertical direction, and
   a plurality of channel layers and a plurality of gate structures are arranged between the plurality of source/drain patterns adjacent to each other.
6. The semiconductor device of clause 5, wherein the plurality of channel layers and the plurality of gate structures are alternately arranged in the vertical direction.
7. The semiconductor device of clause 5 or clause 6, wherein a channel layer of the plurality of channel layers is between the plurality of gate structures at a lowermost end and the plurality of insulating layers.
8. A semiconductor device comprising:
   an active device layer including a first surface extending in a horizontal direction and a second surface opposite to the first surface, and at least one first source/drain pattern and at least one second source/drain pattern;
   a first back end of line (BEOL) structure on the first surface and configured to supply electric power to the active device layer;
   a second BEOL structure on the second surface and configured to route a signal;
   an intermediate layer between the active device layer and the first BEOL structure;
   a plurality of insulating layers between the active device layer and the intermediate layer;
   at least one power via penetrating through the intermediate layer and at least a part of each insulating layer of the plurality of insulating layers in a vertical direction that is perpendicular to the horizontal direction, and the at least one power via electrically connected to the first BEOL structure and the active device layer; and
   at least one contact electrically connected to the active device layer and the second BEOL structure,
   wherein at least a part of a side surface of the at least one power via is in contact with the intermediate layer.
9. The semiconductor device of clause 8, wherein
   the at least one power via overlaps one of the at least one first source/drain pattern in the vertical direction, and is spaced apart from the at least one second source/drain pattern in the horizontal direction in a plan view.
10. The semiconductor device of clause 8 or clause 9, wherein
   a lowermost surface of the at least one first source/drain pattern and a lower surface of each of the at least one second source/drain pattern are at a same vertical level and the vertical level is lower than an uppermost surface of the plurality of insulating layers.
11. The semiconductor device of ay of clauses 8-10, wherein
   the at least one power via includes a first portion having a trapezoidal shape in a vertical section and a second portion having a round shape protruding in a direction toward the at least one first source/drain pattern,
   a side surface of the first portion is in contact with the intermediate layer and at least one of the plurality of insulating layers, and
   a side surface of the second portion is in direct contact with at least one of the plurality of insulating layers and the at least one first source/drain pattern.
12. The semiconductor device of clause 11, wherein
   the plurality of insulating layers include a first insulating layer and a second insulating layer, and
   an upper surface of the first portion is at a vertical level that is the same as a vertical level of an interfacial layer between the first insulating layer and the second insulating layer.
13. The semiconductor device of any of clauses 8-12, wherein
   the plurality of insulating layers include three or more insulating layers, and
   the insulating layer at an uppermost end and the insulating layer at a lowermost end include a same material.
14. A semiconductor device comprising:
   an active device layer including a first surface extending in a horizontal direction and a second surface opposite to the first surface, and at least one first source/drain pattern and at least one second source/drain pattern;
   a first back end of line (BEOL) structure on the first surface and configured to supply electric power to the active device layer;
   a second BEOL structure on the second surface and configured to route a signal;
   an intermediate layer between the active device layer and the first BEOL structure;
   a plurality of insulating layers between the active device layer and the intermediate layer; and
   at least one power via penetrating through the intermediate layer and at least a part of each insulating layer of the plurality of insulating layers in a vertical direction that is perpendicular to the horizontal direction, and the at least one power via electrically connected to the first BEOL structure and the active device layer,
   wherein the at least one first source/drain pattern and the at least one second source/drain pattern are each spaced apart from each other in the horizontal direction,
   a plurality of channel layers and a plurality of first gate structures are alternately arranged in the vertical direction between the first source/drain pattern and the second source/drain pattern that are adjacent to each other,
   a plurality of second gate structures are on a channel layer at an uppermost end of the plurality of channel layers,
   at least one contact electrically connected to the at least one second source/drain pattern and the second BEOL structure,
   at least one second contact electrically connected to the plurality of second gate structures and the second BEOL structure,
   at least a part of a side surface of the at least one power via is in contact with the intermediate layer, and
   the at least one power via includes a first portion having a trapezoidal shape in a vertical section and a second portion having a round shape protruding toward the at least one first source/drain pattern.
15. The semiconductor device of clause 14, wherein a lowermost surface of the at least one first source/drain pattern, a lower surface of the at least one second source/drain pattern, and an upper surface of the first portion are at a same vertical level.

## Claims

1. A semiconductor device comprising:
an active device layer including a plurality of source/drain patterns;
a plurality of insulating layers on the active device layer;
a back end of line, BEOL, structure on the plurality of insulating layers and configured to supply electric power to the active device layer;
an intermediate layer between the plurality of insulating layers and the BEOL structure; and
at least one power via penetrating through the intermediate layer and at least a part of each insulating layer of the plurality of insulating layers in a vertical direction, and the at least one power via electrically connected to the BEOL structure and the active device layer,
wherein at least a part of a side surface of the at least one power via is in contact with the intermediate layer.

2. The semiconductor device of claim 1, wherein at least two of the plurality of insulating layers have different etch selectivities.

3. The semiconductor device of claim 1 or claim 2, wherein
upper surfaces of the plurality of insulating layers have concave or convex shapes, and
an uppermost surface of the plurality of insulating layers is at a vertical level that is higher than a lowermost surface of the plurality of source/drain patterns.

4. The semiconductor device of any preceding claim, wherein at least a part of a side surface of the at least one power via is in contact with the plurality of insulating layers.

5. The semiconductor device of any preceding claim, wherein
the plurality of source/drain patterns are spaced apart from each other in a horizontal direction that is perpendicular to the vertical direction, and
a plurality of channel layers and a plurality of gate structures are arranged between the plurality of source/drain patterns adjacent to each other.

6. The semiconductor device of claim 5, wherein the plurality of channel layers and the plurality of gate structures are alternately arranged in the vertical direction.

7. The semiconductor device of claim 5 or claim 6, wherein a channel layer of the plurality of channel layers is between the plurality of gate structures at a lowermost end and the plurality of insulating layers.

8. A semiconductor device of any preceding claim, wherein:
the active device layer includes a first surface extending in a horizontal direction perpendicular to the vertical direction and a second surface opposite to the first surface;
the plurality of source/drain patterns includes at least one first source/drain pattern and at least one second source/drain pattern;
the BEOL structure is a first BEOL structure on the first surface; and
the semiconductor device further comprises:
a second BEOL structure on the second surface and configured to route a signal; and
at least one contact electrically connected to the active device layer and the second BEOL structure.

9. The semiconductor device of claim 8, wherein
the at least one power via overlaps one of the at least one first source/drain pattern in the vertical direction, and is spaced apart from the at least one second source/drain pattern in the horizontal direction in a plan view.

10. The semiconductor device of claim 8 or claim 9, wherein
a lowermost surface of the at least one first source/drain pattern and a lower surface of each of the at least one second source/drain pattern are at a same vertical level and the vertical level is lower than an uppermost surface of the plurality of insulating layers.

11. The semiconductor device of any of claims 8-10, wherein
the at least one power via includes a first portion having a trapezoidal shape in a vertical section and a second portion having a round shape protruding in a direction toward the at least one first source/drain pattern,
a side surface of the first portion is in contact with the intermediate layer and at least one of the plurality of insulating layers, and
a side surface of the second portion is in direct contact with at least one of the plurality of insulating layers and the at least one first source/drain pattern.

12. The semiconductor device of claim 11, wherein
the plurality of insulating layers include a first insulating layer and a second insulating layer, and
an upper surface of the first portion is at a vertical level that is the same as a vertical level of an interfacial layer between the first insulating layer and the second insulating layer.

13. The semiconductor device of any of claims 8-12, wherein
the plurality of insulating layers include three or more insulating layers, and
the insulating layer at an uppermost end and the insulating layer at a lowermost end include a same material.

14. The semiconductor device of any of claims 8-13, wherein:
the at least one first source/drain pattern and the at least one second source/drain pattern are each spaced apart from each other in the horizontal direction,
a plurality of channel layers and a plurality of first gate structures are alternately arranged in the vertical direction between the first source/drain pattern and the second source/drain pattern that are adjacent to each other,
a plurality of second gate structures are on a channel layer at an uppermost end of the plurality of channel layers,
at least one second contact is electrically connected to the plurality of second gate structures and the second BEOL structure, and
the at least one power via includes a first portion having a trapezoidal shape in a vertical section and a second portion having a round shape protruding toward the at least one first source/drain pattern.

15. The semiconductor device of claim 14, wherein a lowermost surface of the at least one first source/drain pattern, a lower surface of the at least one second source/drain pattern, and an upper surface of the first portion are at a same vertical level.
